# EUROPEAN PATENT SPECIFICATION

(11) **EP 2 554 935 B1**
(45) Date of publication and mention of the grant of the patent: **26.02.2014**
(21) Application number: 11464009.7
(22) Date of filing: 01.08.2011
(51) Int. Cl.: F28F 13/14, F28F 13/18, H05K 7/20

(54) **Apparatus for passive cooling**
Vorrichtung zur passiven Kühlung
Appareil de refroidissement passif

(43) Date of publication of application: 06.02.2013
(73) Proprietor: Continental Automotive GmbH, 30165 Hannover (DE)
(72) Inventor: Birdeanu, Mircea Cristian, 300481 Timisoara (RO); Caragea, George-Dan, 310377 Arad (RO); Obreja, Cosmin, 300086 Timisoara (RO)

(56) References cited:
- DE-A1- 4 313 782
- US-A1- 2002 063 223
- US-A1- 2006 086 494
- US-A1- 2008 117 599

## Description

The invention relates to an apparatus for passive cooling.

The thermal demands imposed on electronics are becoming greater in the area of electronic control units (ECU) for engine management systems of an automobile. This can essentially be attributed to the inclusion of an increasing number of engine management functions which require additional electro-mechanical and electrical components. Another reason is that an increasing number of components are assembled close to each other in the car. For example the proximity to the engine area imposes especially high requirements on the temperature stability of electronic control devices. Such a close proximity can lead to temperatures being able to exceed permitted limits in particular at the internal electrical connections, such as solder points, as well as in electrical components, such as ASICs, itself. As a result problems in functionality and life-time of these electrical components can occur. Therefore, an extensive cooling is required which avoids failures in the operation of the components and the corresponding circuits.

Known cooling arrangements use for example liquids which are passed through tubes or other cavities which are mounted next to the devices to be cooled. Another way of cooling is by using a complex housing shape which inhibits an increased surface. Such arrangements require additional apparatus', such as a number of cooling fins, which can lead to a substantial increase of weight and size of the whole product. This contrasts the general request from the car manufacturers today of a decrease in size for electronic control units while at least the functionalities should be maintained. As a consequence also the cooling space-area for the electronic components has to be reduced in size and weight.

US 2006/0086494 A1 discloses a system having a heat source unit, and a first heat releasing member arranged on the heat source unit or at a location near the heat source unit, to convert heat into a far infrared ray and radiate the far infrared ray.

The object of the invention is to create an apparatus for cooling which requires little space and is easy to implement.

This object is achieved by an apparatus for passive cooling with the features of claim 1. Advantageous embodiments which can be used individually or in combination are the subject matter of the dependent claims.

The apparatus for passive cooling according to the invention comprises a surface with at least two regions each of which cause different thermal radiation. The regions are repeated for establishing a contrasted pattern throughout a part of the surface or the whole surface. In this context the meaning of thermal radiation is absorption and emission of radiation. In case there is thermal radiation emitted a difference in thermal radiation will occur which leads consequently to air convection and turbulence between those different radiations. As a result, the heat will be dissipated away from the housing's outside surface. The overall heat dissipation is improved. The advantage of the regions being repeated for establishing a contrasted pattern throughout a part of the surface or the whole surface is that the effect of cooling due to the difference in thermal radiation and the occurring air convection happens between each neighboring region, i.e. at all interfaces with regions with different thermal radiations. The overall cooling effect will be enhanced.

In a preferred embodiment of the invention the apparatus is part of a housing for electronic devices. The required space for the housing is not increasing significantly due to the additional apparatus, because the apparatus is only covering the surface.

The housing requires less space and material because some of the cooling is undertaken by the apparatus for passive cooling which requires little space and material.

In another preferred embodiment the housing is part of an electronic control unit (ECU) for engine management systems of an automobile. In particular for ECUs in automotive applications it is advantageous to have compact units which require little space with equal or improved cooling power. The invention is providing such an apparatus.

In another preferred embodiment the regions comprise different colors. In this context the meaning of color is the visual perceptual property corresponding to humans to the categories such as blue, green or red or others alike. Therefore, colors are recognizable by the human eye, and are easy to process and handle.

In another preferred embodiment the regions comprise different shapes. By applying different shapes the geometry of the regions can be optimized with respect to a maximum of heat dissipation.

In another preferred embodiment the different colors appear identical in the visual electromagnetic range while having different radiation behavior in the infrared electromagnetic range. The effect of cooling can be achieved without having for the human eye recognizable different colors at the surface. In this context the meaning of visual range is a wavelength- or frequency-range of electromagnetic waves which are referred to be visual, i.e. recognizable by the human eye. The visual range of electromagnetic waves is typically at wavelengths around 380nm to 780nm. In order to verify whether colors appear identical in the visual range color classifications such as the RAL-classification by the German RAL-Institute can be applied. In this context the meaning of infrared range is a wavelength or frequency range of electromagnetic waves which have corresponding wavelengths typically around 780nm to 1mm.

In a further preferred embodiment at least one of the regions comprises paint or lacquer. Paint or lacquer has the advantage that it can be easily deposited onto a surface and is very thin and therefore requires little additional space.

In a further preferred embodiment at least one of the regions comprises a mass-colored material. In this context the meaning of a mass-colored material is a material which comprises a color throughout the whole material and not only at the surface. A commonly known mass-colored material is plastic. The material can be directly processed without a further processing step, such as depositing paint on a piece of material.

Further advantages and embodiments of the invention will be explained below on the basis of an exemplary embodiment shown in the drawings.

The figures show the following schematic diagrams:
- Fig. 1: apparatus for passive cooling with different regions at a surface; and
- Fig. 2: apparatus for passive cooling with longitudinal black and white stripes; and
- Fig. 3: apparatus for passive cooling with lateral black and white stripes.

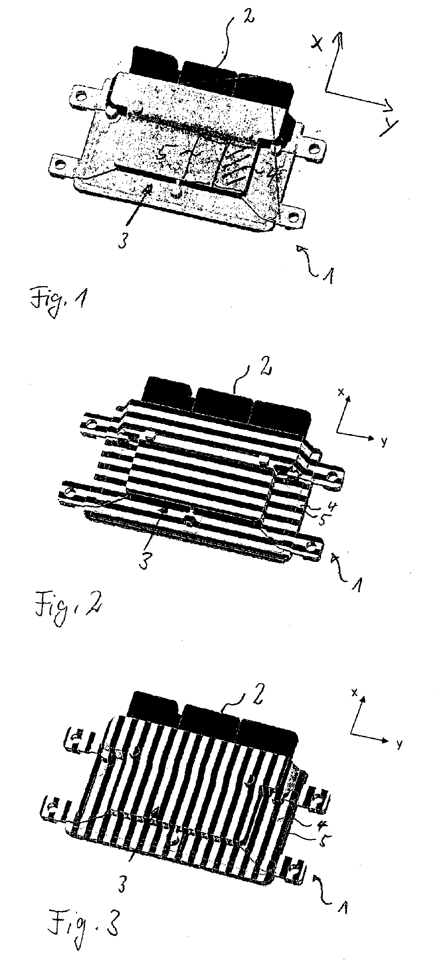

Figure 1 shows a perspective view of an apparatus not falling within the scope of the claims, for passive cooling with a surface 3. The apparatus can be part of a housing 1. The housing 1 can be part of an electronic control unit (ECU) for engine management systems of an automobile, or any other electronic unit used in an automobile. The housing 1 can further comprise connectors 2 which can be electrically connected to the ECU.

In order to cool the electronic circuits the housing 1 needs to be cooled. According to the invention two regions 4, 5 are assembled at the surface 3. Each of those regions 4, 5 can emit different thermal radiation. This further causes air convection and turbulence between those two different emissions of radiation. As a consequence the heat is dissipated and a cooling effect at the surface 3 occurs. If the surface 3 is part of a housing 1 a cooling effect at the housing 1 occurs.

Figure 2 shows an apparatus as in figure 1, wherein the regions 4, 5 comprise at least two stripes 4, 5. Those stripes 4, 5 can comprise different colors, for example black and white. These two colors have a very strong contrast to each other and accordingly a different behavior with regard to thermal radiation. Therefore, the thermal radiation from those colors is very different and hence, the air convection and turbulence effect is very strong which causes a significant cooling effect.

The stripes 4, 5 are assembled in the longitudinal axis y of the housing 1 and are repeated throughout the surface 3, so that they cover all surface 3. It is also possible that those stripes 4, 5 are repeated only at a part of the surface 3, and not all surface 3 is covered with the stripes 4, 5.

The two different colors cause different thermal radiation, which means different thermal absorption and/or emission. Therefore, between each neighboring stripe 4, 5 different thermal radiation occurs. This causes air convection and turbulence between those two different radiations. The stripes 4, 5 have the advantage of a large length to width ratio. This leads to a better ratio of the amount of emitted thermal radiation, which contributes to the convection with the emitted radiation of the neighboring stripe 4, 5, to the total thermal radiation emitted by a stripe 4, 5.

This effect occurs between every neighboring black and white stripe 4, 5 and therefore throughout a part or all the surface 3 of the housing 1. As a result an overall cooling of the housing 1 is achieved.

It has been found advantageous if at least one of the stripes 4, 5 is assembled in a straight line parallel to the longitudinal axis y or parallel to the lateral axis x of the surface 3 of the apparatus. A significant reduction in heat could be observed.

Figure 3 shows an apparatus as in figure 2, wherein the different colored stripes 4, 5 are assembled in the lateral direction x of the surface 3 of the housing 1. In principle, the same effect of air convection and turbulence occurs as described in figure 1 and 2. However, due to the different side-lengths in lateral x and longitudinal y direction of the housing 1 the stripes 4, 5 in the lateral axis x have a different length compared to those in the longitudinal axis y. Also, the shape of the surface 3 is different with respect to the assembly of the stripes 4, 5. Experiments have shown that the overall reduction in heat or the heat dissipation is different, depending if the stripes 4, 5 are assembled in the lateral x or longitudinal y direction. The heat dissipation at the surface 3 can be adjusted by choosing the direction of the stripes 4, 5 in relation to the shape of the surface 3.

A stripe width of 5 mm can be advantageous. This applies for both stripes 4, 5 assembled in the longitudinal direction y and lateral direction x. In general, any stripe 4, 5 width can be applied. Also, it is possible that the stripes 4, 5 have different widths. For example the stripe width of a white stripe 4, 5 could be much larger than that of a black stripe 4, 5, which would cause a different air convection behavior.

Also, it is favorable that the shape of the stripes 4, 5 is not a straight line but a circle or curved line or any other shape. Those stripe shapes can cover parts or all surface 3.

The stripes 4, 5 can have any shape which is advantageously for the passive cooling of a surface 3 and/or a housing 1. For example at least one stripe 4, 5 can be assembled in a straight line parallel to the longitudinal y or lateral axis x of the cooling apparatus or at least one stripe 4, 5 comprises at least one curvature.

The shape of the regions 4, 5 can in general comprise any geometrical shape, such as triangles, circles or squares. The shape of the regions 4, 5 which cause different thermal radiation can be equal or different.

Furthermore, there can be more than two regions 4, 5 which can comprise more than two colors. A combination of different colors and different stripe shapes or different shapes of the regions 4, 5 is possible.

The regions 4, 5, covering parts or the whole surface 3 can also comprise a bare metal with electromagnetic wavelengths in the infrared region, which is typically in the range of 780nm to 1mm. Bare metals have a low emissivity in the order of 0,1. In that respect it is preferred that the other region 4, 5 comprises a material with a much higher emissivity, such as paint or oxide which have an emissivity above 0,9. A large difference in the emissivity of the regions 4, 5 can cause a stronger convection effect.

In general, any combination of the above described properties of the regions 4, 5 with regard to shape, color and material can be applied. For example, there can be curved stripes 4, 5 whereas one stripe comprises metal, the other one paint; both can have the same or a different width. Also, the shape can be identical, such as curved, or different, so that one stripe is curved the other one is a straight line, or one region 4, 5 comprises a square whereas the other region 4, 5 comprises a circle.

It is also possible to use further properties of the surface 3 for improving the cooling-effect, such as the roughness and the shape of the surface 3. Also, a dedicated geometry to define regions 4, 5 which are exposed or shadowed with regard to the radiation or external influences is a possible implementation. This causes a different interaction of the thermal radiation of the regions 4, 5 and therefore, a different convection.

By using the apparatus with regions 4, 5 each of which cause different thermal radiation, such as different colored regions 4, 5, at a surface 3 of a cooling apparatus a very easy way is established for cooling. Preferably this apparatus is part of a housing 1 which is part of an electronic control unit (ECU) for engine management systems of an automobile

This invention can also be applied to all kinds of surfaces which require cooling. Those can be vehicles, trains, buildings, tents or housings for electronic products in general.

This invention can generally also be used for warming devices. The physical effect of convection applies in either ways for warming and for cooling. In order to use convection for warming it is required that the surrounding temperature is larger than the temperature of the device to be warmed.

## Claims

1. Apparatus for passive cooling comprising a surface (3) with at least two regions (4, 5) of different emissivity each of which cause different thermal radiation,
**characterized in that** the regions (4, 5) are contiguous and are repeated for establishing a contrasted pattern throughout a part of the surface (3) or the whole surface (3) in order to generate air convection at the interfaces of said regions with different emissivity.

2. Apparatus for passive cooling according to claim 1, wherein the apparatus is part of a housing (1).

3. Apparatus for passive cooling according to claim 2, wherein the housing (1) is part of an electronic control unit (ECU) for engine management systems of an automobile.

4. Apparatus for passive cooling according to claims 1 to 3, wherein the regions (4, 5) comprise different colors.

5. Apparatus for passive cooling according to claims 1 to 3, wherein the regions (4, 5) comprise different shapes.

6. Apparatus for passive cooling according to claim 4, wherein the different colors appear identical in the visual electromagnetic range while having different radiation behavior in the infrared electromagnetic range.

7. Apparatus for passive cooling according to claims 1 to 6, wherein at least one of the regions (4, 5) comprise paint or lacquer.

8. Apparatus for passive cooling according to claims 1 to 7, wherein at least one of the regions (4, 5) comprises a mass-colored material.

## Patentansprüche

1. Vorrichtung zur passiven Kühlung, umfassend eine Oberfläche (3) mit mindestens zwei Bereichen (4, 5) von unterschiedlichem Wärmeabgabevermögen, deren jeder eine unterschiedliche Wärmestrahlung hervorruft,
**dadurch gekennzeichnet, dass** die Bereiche (4, 5) aneinander angrenzen und wiederholt werden, um über einen Teil der Oberfläche (3) oder über die gesamte Oberfläche (3) hinweg ein kontrastreiches Muster zu erzeugen.

2. Vorrichtung zur passiven Kühlung gemäß Anspruch 1, wobei die Vorrichtung Teil eines Gehäuses (1) ist.

3. Vorrichtung zur passiven Kühlung gemäß Anspruch 2, wobei das Gehäuse (1) Teil einer elektronischen Steuerungseinheit (ECU, Electronic Control Unit) für Motor-Managementsysteme eines Automobils ist.

4. Vorrichtung zur passiven Kühlung gemäß den Ansprüchen 1 bis 3, wobei die Bereiche (4, 5) unterschiedliche Farben aufweisen.

5. Vorrichtung zur passiven Kühlung gemäß den Ansprüchen 1 bis 3, wobei die Bereiche (4, 5) unterschiedliche Formen aufweisen.

6. Vorrichtung zur passiven Kühlung gemäß Anspruch 4, wobei die unterschiedlichen Farben in dem visuellen elektromagnetischen Bereich identisch zu sein scheinen, während sie in dem infraroten elektromagnetischen Bereich unterschiedliches Strahlungsverhalten aufweisen.

7. Vorrichtung zur passiven Kühlung gemäß den Ansprüchen 1 bis 6, wobei mindestens einer der Bereiche (4, 5) Anstrichfarbe oder Lack umfasst.

8. Vorrichtung zur passiven Kühlung gemäß den Ansprüchen 1 bis 7, wobei mindestens einer der Bereiche (4, 5) in der Masse gefärbtes Material umfasst.

## Revendications

1. Appareil de refroidissement passif comprenant une surface (3) dotée d'au moins deux zones (4, 5) qui présentent une émissivité différente, chacune d'elles provoquant un rayonnement thermique différent ;
**caractérisé en ce que** les zones (4, 5) sont contigües et sont répétées pour établir un motif contrasté sur une partie de la surface (3) ou sur la totalité de la surface (3) afin de générer une convection d'air au niveau des interfaces desdites zones qui présentent une émissivité différente.

2. Appareil de refroidissement passif selon la revendication 1, dans lequel l'appareil fait partie d'un logement (1).

3. Appareil de refroidissement passif selon la revendication 2, dans lequel le logement (1) fait partie d'une unité de commande électronique (UCE) de systèmes de gestion du moteur d'un véhicule automobile.

4. Appareil de refroidissement passif selon les revendications 1 à 3, dans lequel les zones (4, 5) comprennent des couleurs différentes.

5. Appareil de refroidissement passif selon les revendications 1 à 3, dans lequel les zones (4, 5) comprennent des formes différentes.

6. Appareil de refroidissement passif selon la revendication 4, dans lequel les différentes couleurs apparaissent de manière identique dans la plage électromagnétique visible tout en présentant des comportements de rayonnement différents dans la plage électromagnétique infrarouge.

7. Appareil de refroidissement passif selon les revendications 1 à 6, dans lequel au moins l'une des zones (4, 5) comprend une peinture ou une laque.

8. Appareil de refroidissement passif selon l'une quelconque des revendications 1 à 7, dans lequel au moins l'une des zones (4, 5) comprend un matériau teinté dans la masse.
